# FASCICULE DE BREVET EUROPEEN

(11) **EP 2 304 824 B1**
(45) Date de publication et mention de la délivrance du brevet: **14.12.2016**
(21) Numéro de dépôt: 09794005.0
(22) Date de dépôt: 26.06.2009
(51) Int. Cl.: H01L 51/52

(54) **DISPOSITIF ELECTROLUMINESCENT D'AFFICHAGE, D'ECLAIRAGE OU DE SIGNALISATION, ET SON PROCEDE DE FABRICATION**
ELEKTROLUMINESZENTE ANZEIGEVORRICHTUNG, BELEUCHTUNGSVORRICHTUNG ODER SIGNALISIERUNGSVORRICHTUNG UND VERFAHREN ZU IHRER HERSTELLUNG
ELECTROLUMINESCENT DISPLAY, ILLUMINATION OR INDICATING DEVICE, AND ITS FABRICATION PROCESS

(30) Priorité: 07.07.2008 FR 0803841
(43) Date de publication de la demande: 06.04.2011
(73) Titulaire: Commissariat à l'Énergie Atomique et aux Énergies Alternatives, 75015 Paris (FR)
(72) Inventeur: VAUFREY, David, F-38000 Grenoble (FR); MAINDRON, Tony, F-38000 Grenoble (FR)
(74) Mandataire: Gevers & Orès
(86) Numéro de dépôt international: PCT/FR2009/000798
(87) Numéro de publication internationale: WO 2010/004124

(56) Documents cités:
- WO-A-2005/071771
- US-A- 5 739 545
- US-A- 5 952 778
- US-A1- 2003 143 319
- US-A1- 2004 099 862
- US-A1- 2007 172 971

## Description

La présente invention concerne un dispositif électronique d'affichage, d'éclairage ou de signalisation à unité(s) électroluminescente(s) comportant au moins deux électrodes entre lesquelles est intercalée une structure émettrice de lumière, et un procédé de fabrication de ce dispositif. L'invention s'applique d'une manière générale à de tels dispositifs à matrice active ou passive, tels que des microafficheurs ou microécrans (« microdisplays » en anglais), à titre non limitatif.

De manière connue, les dispositifs d'affichage à unité électroluminescente, comme par exemple ceux à diodes électroluminescentes organiques (« OLED » pour « organic light-emitting diode ») comportent, déposées sur un substrat semi-conducteur :
- une zone d'émission lumineuse formée par une structure émettrice de lumière qui comprend au moins un film organique et qui est intercalée entre deux électrodes interne et externe dont l'une au moins est transparente ou semi-transparente à la lumière émise, l'électrode externe étant fine ou relativement épaisse selon que l'on souhaite une émission respectivement par la face externe de cette zone ou à travers le substrat, et
- une zone de contact électrique, qui est en général agencée de manière adjacente à cette zone d'émission et qui comprend au moins une zone de contact avec l'électrode interne et une zone de contact avec l'électrode externe, chaque zone pouvant être constituée physiquement d'une pluralité de connexions afin de minimiser les résistances d'accès.

L'encapsulation des unités « OLED » est un sujet critique à l'origine de beaucoup de recherches. Ces unités sont usuellement protégées de l'humidité et de l'oxygène de l'air ambiant de deux manières différentes :
- soit par un capot de protection par exemple en verre, moulé de sorte à présenter un bord périphérique en saillie vers l'intérieur et collé par ce seul bord à la périphérie de la zone d'émission du dispositif, pour ne pas altérer l'empilement « OLED » par la pression d'assemblage,
- soit par une ou plusieurs couche(s) mince(s) d'encapsulation déposée(s) sur la zone d'émission et comprenant typiquement des alternances de matériaux organiques et inorganiques afin de répondre aux spécifications requises en termes de perméabilités.

Un inconvénient majeur du premier mode d'encapsulation précité réside, d'une part, dans la nécessité de façonner le bord en saillie de ce capot lors du moulage et, d'autre part, dans la superficie réduite de l'interface de collage obtenue qui n'est pas toujours apte à garantir une efficacité d'encapsulation pérenne.

Concernant le second mode d'encapsulation précité, il est connu, pour les unités « OLED » à émission par la face externe (i.e. supérieure), de déposer sur l'électrode externe une fine couche de recouvrement (« capping layer » en anglais) transparente à la lumière visible, qui est généralement constituée d'un matériau diélectrique d'indice optique supérieur à 1,8 afin d'extraire les photons de l'unité « OLED ». Cette couche de recouvrement doit en outre être déposée par une méthode « douce » (i.e. utilisant une température réduite, un bombardement très peu énergétique et une faible présence d'espèces oxydantes et d'eau) telle que l'évaporation sous vide, pour ne pas perturber les propriétés électro-optiques des semiconducteurs organiques sous-jacents.

Les couches de recouvrement ainsi déposées présentent l'inconvénient d'être insuffisamment denses et pas assez « conformantes » (i.e. n'épousant pas de manière satisfaisante les micro- ou nanoreliefs des surfaces qu'elles recouvrent), ce qui pénalise l'efficacité de l'encapsulation.

Le document US-A-2002/0003403 présente un dispositif « OLED » à deux couches d'encapsulation superposées sur la zone d'émission et respectivement constituées d'une couche d'oxyde diélectrique par exemple déposée par un dépôt de couche atomique (« ALD » pour « Atomic Layer Deposition »), et d'une couche polymérique par exemple en parylène. On peut également citer les documents US-A-2007/0099356, US2007/0172971, US 2003/0143319 et US-A-2007/0275181 qui enseignent d'utiliser la technique « ALD » pour déposer une couche d'encapsulation sur des unités électroluminescentes.

Ces couches d'encapsulation déposées par « ALD » présentent l'avantage d'être « conformantes » tout en présentant une densité élevée, ce qui leur confère des propriétés de barrière relativement satisfaisantes vis-à-vis de l'humidité et de l'oxygène ambiants. Néanmoins, un inconvénient de ces couches déposées par « ALD » réside dans l'utilisation de précurseurs du dépôt « ALD » qui contiennent des oxydants et de l'eau, susceptibles d'altérer les caractéristiques de l'unité « OLED » sous-jacente. Les précurseurs sont d'autant plus réactifs que le dépôt « ALD » est réalisé à basse température.

Le document WO2005/071771 décrit un dispositif OLED présentant une cathode ayant une structure d'interférence optique afin d'augmenter l'émission de lumière au travers de la cathode.

Un but de la présente invention est de proposer un dispositif électronique d'affichage, d'éclairage ou de signalisation comprenant un substrat revêtu sur l'une au moins de ses faces d'une unité électroluminescente comportant au moins deux électrodes interne et externe entre lesquelles est intercalée une structure émettrice de lumière et dont l'une au moins est transparente à la lumière émise, une plaque de protection étant assemblée sur l'unité par l'intermédiaire d'une colle recouvrant une face d'assemblage de la plaque, ce dispositif permettant de remédier aux inconvénients précités en relation avec les deux modes d'encapsulation susmentionnés.

A cet effet, un dispositif selon l'invention est tel que cette colle recouvre également une couche promotrice d'adhésion qui surmonte l'unité en étant déposée par un dépôt « ALD » à base de précurseurs et qui est à base d'au moins un composé inorganique compatible avec la colle, une sous-couche réactive métallique ayant réagi avec au moins un de ces précurseurs étant intercalée sous et au contact de cette couche promotrice d'adhésion, au moins une couche intermédiaire (8) diélectrique et transparente à la lumière émise étant disposée entre l'électrode externe et ladite sous-couche réactive pour former avec ces dernières une cavité résonnante.

On notera que cet empilement électrode externe / couche(s) intermédiaire(s) / sous-couche réactive métallique permet ainsi de former une cavité résonnante et plus particulièrement un miroir de Bragg, permettant un élargissement significatif de la bande passante de la lumière émise en comparaison de la bande passante relativement étroite caractérisant des dispositifs qui seraient dépourvus d'une telle couche intermédiaire entre l'électrode externe et la couche métallique.

On notera également que cette synergie entre la sous-couche réactive et la couche promotrice d'adhésion permet de faire en sorte que les couches sous-jacentes de l'unité soient protégées lors du dépôt par « ALD » et que la couche promotrice d'adhésion se conforme aux reliefs des surfaces qu'elle recouvre en étant stable et transparente à la lumière émise par l'unité. Cette sous-couche réactive, qui est intercalée entre l'électrode externe et la couche promotrice d'adhésion, interagit en effet avec cette dernière de sorte que son dépôt par « ALD » soit sans conséquences néfastes pour l'électrode externe et les composants de la structure émettrice sous-jacente.

On notera en outre que la combinaison de la sous-couche réactive et de la couche promotrice d'adhésion dense et « conformante » permet de procurer une qualité d'encapsulation nettement améliorée en comparaison des capots de protection collés en leur seule périphérie autour de l'unité électroluminescente, du fait que cette combinaison rend possible le collage par pression d'une plaque de protection sur toute la surface de sa face d'assemblage et de l'unité en regard, sans dommage pour les divers composants sous-jacents du fait de la densité de cette couche combinée à la protection assurée par la sous-couche réactive. Il en résulte des propriétés d'imperméabilité améliorées à l'oxygène et à l'humidité extérieurs.

Selon une autre caractéristique de l'invention, ladite ou chaque couche intermédiaire est à base d'au moins un composé diélectrique de préférence choisi dans le groupe constitué par ceux de formule SiOx, ZnSe, ZnO, Sb₂O₃ et les oxydes transparents conducteurs (OTC) et notamment les oxydes d'étain-indium, elle présente une épaisseur comprise entre 5 nm et 35 nm et elle peut avantageusement être déposée par une technique d'évaporation sous vide.

Selon une autre caractéristique de l'invention, ladite colle peut recouvrir la totalité de ladite face d'assemblage de la plaque, laquelle face est avantageusement sensiblement plate.

On notera que cette application de la couche promotrice d'adhésion sur sensiblement la totalité de l'interface de collage facilite l'opération de collage ultérieure, du fait que l'on n'a pas à recourir à un dépôt sélectif de cette couche sur l'interface de collage, laquelle est ainsi optimale.

Par conséquent, l'opération de moulage de la plaque pour lui conférer un bord périphérique saillant vers l'intérieur n'est plus requise, grâce à la présente invention qui permet l'utilisation d'une plaque entièrement plate sur ses deux faces.

De préférence, le composé inorganique de la couche promotrice d'adhésion est choisi dans le groupe constitué par les oxydes d'aluminium, les oxydes de silicium (par exemple de formule SiO₂), les oxydes de zinc de formule ZnO et les nitrures de silicium de formule SiₓN_{y}.

Egalement à titre préférentiel, ladite sous-couche réactive est constituée d'au moins un élément métallique, tel que l'aluminium ou le calcium, et présente une épaisseur inférieure ou égale à 10 nm.

Quant à la couche promotrice d'adhésion, elle peut avantageusement présenter une épaisseur comprise entre 10 nm et 100 nm, en particulier selon que l'on souhaite privilégier la couleur (i.e. la luminance et la radiance) ou bien l'efficacité lumineuse obtenue, notamment pour un matériau et une épaisseur d'électrode externe et des couleurs d'émission déterminés.

De préférence, ladite couche promotrice d'adhésion présente une épaisseur comprise entre 20 nm et 80 nm, et ladite sous-couche réactive présente une épaisseur comprise entre 1 nm et 10 nm.

Avantageusement, ladite couche promotrice d'adhésion est constituée d'un oxyde d'aluminium de formule Al₂O₃, et ladite sous-couche réactive peut être dans ce cas constituée d'aluminium.

Selon une autre caractéristique de l'invention, l'électrode externe peut être constituée d'au moins un métal transparent ou semi-transparent à la lumière émise, de préférence l'argent, l'aluminium ou le samarium.

Avantageusement, ladite colle utilisée pour l'assemblage par pression de la plaque de protection sur l'unité électroluminescente est choisie réticulable par un rayonnement ultraviolet, telle qu'une colle de type acrylate ou époxy, et cette plaque est choisie transparente à ce rayonnement.

On notera que ladite couche promotrice d'adhésion permet d'améliorer l'adhésion de cette colle tant à la plaque qu'aux couches sous-jacentes de l'unité électroluminescente, et qu'elle est choisie compatible avec les colles notamment de type acrylate ou époxy et avec les composants de ces couches sous-jacentes.

Selon une autre caractéristique de l'invention, le dispositif peut être dépourvu de toute couche organique d'encapsulation (e.g. une couche polymérique telle que celle divulguée dans le document US-A-2002/0003403 précité) surmontant l'électrode externe, la couche de colle exceptée.

Selon une autre caractéristique de l'invention, ladite unité peut être de type à diodes électroluminescentes organiques (« OLED »), étant précisé que tous autres composants électroluminescents pourraient être utilisés.

D'une manière générale, le substrat du dispositif de l'invention est semi-conducteur, étant de préférence en silicium, et ladite plaque est réalisée en un matériau transparent à la lumière émise par l'unité électroluminescente, comme le verre ou une matière plastique.

Dans le cas particulier d'un dispositif d'affichage comportant un microécran couleur, on notera que cette plaque de protection peut être pourvue de filtres optiques colorés ou de moyens changeurs de couleurs sur sa face d'assemblage, de telle manière que ces filtres ou ces moyens soient disposés en regard des points de couleur correspondants de chacun des pixels du microécran.

Un procédé de fabrication selon l'invention d'un dispositif tel que défini ci-dessus comprend les étapes suivantes :
a) un dépôt sur ladite électrode externe, par exemple par évaporation sous vide, d'au moins une couche intermédiaire qui est transparente à la lumière émise par l'unité électroluminescente et qui est à base d'au moins un composé diélectrique de préférence choisi dans le groupe constitué par ceux de formule SiOₓ, ZnSe, ZnO, Sb₂O₃ et les oxydes transparents conducteurs (OTC) et notamment les oxydes d'étain-indium, cette couche intermédiaire étant destinée à former une cavité résonnante avec cette électrode externe et la sous-couche réactive de l'étape b),
b) un dépôt sur la couche intermédiaire d'une sous-couche réactive d'au moins un métal, tel que l'aluminium ou le calcium,
c) un dépôt par « ALD » d'une couche promotrice d'adhésion à base d'au moins un composé inorganique compatible avec la colle et de préférence choisi dans le groupe constitué par les oxydes d'aluminium, les oxydes de silicium, les oxydes de zinc et les nitrures de silicium, de manière que la sous-couche réactive réagisse avec au moins un précurseur de ce dépôt, pour protéger les couches sous-jacentes de l'unité des effets du dépôt « ALD » et pour que la couche promotrice d'adhésion se conforme aux reliefs des surfaces qu'elle recouvre en étant stable et transparente à la lumière émise,
d) une application de la colle sur la couche promotrice d'adhésion et/ou sur ladite face d'assemblage de la plaque de protection, pour que cette colle recouvre sensiblement la totalité de cette couche externe et de cette face d'assemblage sensiblement plate, puis
e) un collage de la plaque sur l'unité revêtue de cette couche promotrice d'adhésion, par exemple réalisé via une réticulation de cette colle par un rayonnement ultraviolet.

On notera que ce dépôt par « ALD » peut être mis en oeuvre à basse température et permet d'obtenir une couche de densité élevée et de perméabilité très réduite qui épouse au plus près les micro- ou nanoreliefs des surfaces en regard, et que cette technique « ALD » ne saurait être confondue avec une méthode de dépôt chimique en phase vapeur (« CVD » pour « Chemical Vapor Deposition » en anglais) ou d'évaporation, méthodes non « conformantes » qui ne sont pas utilisables pour le dépôt de la couche promotrice d'adhésion selon l'invention.

On notera également que cette couche promotrice d'adhésion est choisie suffisamment imperméable pour éviter l'agression des solvants de la colle tant à l'encontre des couches sous-jacentes que des filtres ou moyens changeurs de couleur éventuellement prévus sur la plaque.

D'autres avantages, caractéristiques et détails de l'invention ressortiront du complément de description qui va suivre en référence à des dessins annexés, donnés uniquement à titre d'exemples et dans lesquels :

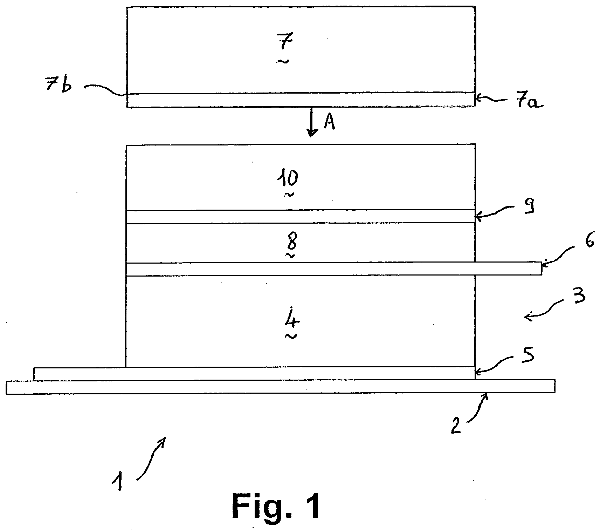

la figure 1 est une vue schématique éclatée en section transversale d'une unité électroluminescente et d'une plaque de protection destinées à former après collage un dispositif électronique selon l'invention,

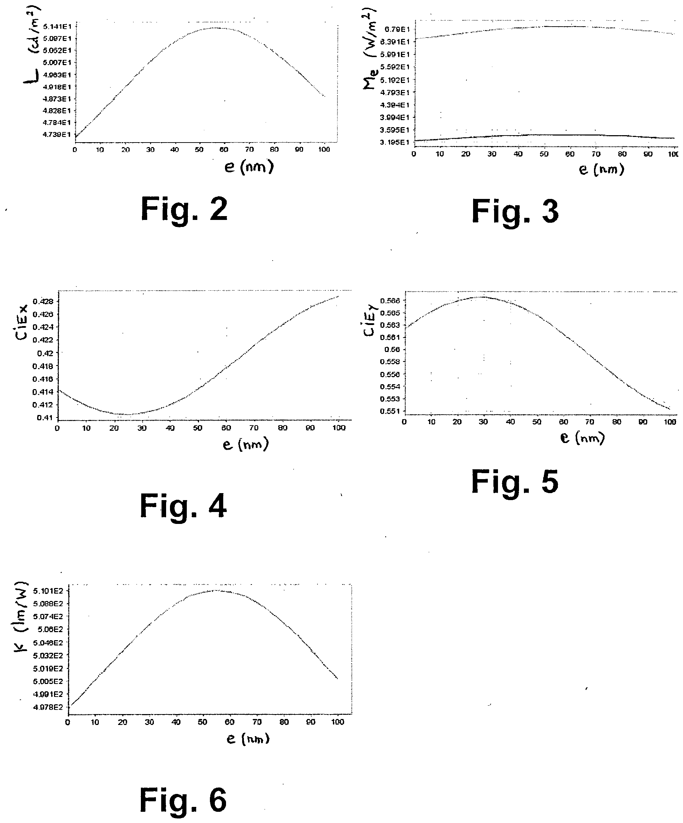

les figures 2 à 6 sont des graphiques illustrant la variation en fonction de l'épaisseur de la couche externe promotrice d'adhésion, dans un premier exemple de réalisation d'un dispositif selon l'invention, respectivement de la luminance lumineuse L, de la radiance Me, du paramètre colorimétrique CIE x, du paramètre colorimétrique CIE y et de l'efficacité lumineuse K, et

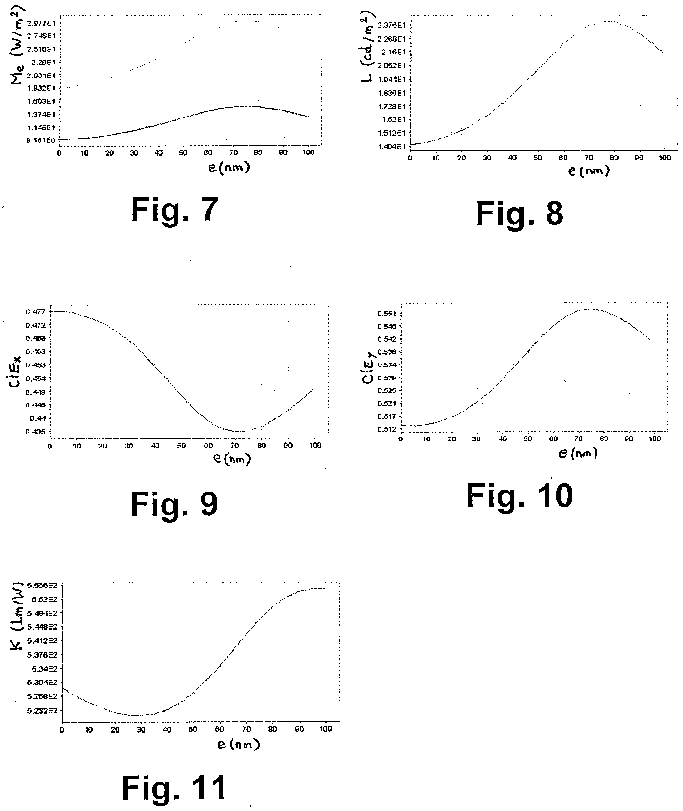

les figures 7 à 11 sont des graphiques illustrant la variation en fonction de l'épaisseur de la couche externe promotrice d'adhésion, dans un second exemple ne faisant pas partie de la présente invention, respectivement de la radiance Me, de la luminance lumineuse L, du paramètre colorimétrique CIE x, du paramètre colorimétrique CIE y et de l'efficacité lumineuse K.

Le dispositif d'affichage électronique 1 illustré à la figure 1 est par exemple de type « OLED », comprenant de manière connue un substrat 2 typiquement en silicium revêtu d'une unité électroluminescente 3 comportant une structure émettrice de lumière 4 intercalée entre deux électrodes interne 5 et externe 6 dont l'une au moins (dans cet exemple l'électrode externe 6) est transparente ou semi-transparente à la lumière émise par la structure 4 afin de faire rayonner la lumière émise vers l'extérieur du dispositif 1. L'électrode externe 6 (semi)transparente est de préférence constituée d'un métal tel que l'argent, l'aluminium ou le samarium pour les propriétés de transparence de ces métaux dans le domaine visible ainsi que pour leur conductivité électrique à faible épaisseur (l'épaisseur de l'électrode externe 6 est par exemple comprise entre 10 nm et 30 nm).

La structure émettrice « OLED » est par exemple constituée d'un empilement de films organiques conçu pour transférer les électrons et les trous qui proviennent des électrodes 5 et 6 et qui sont recombinés pour générer des excitons et donc l'émission de lumière.

Comme illustré à la figure 1, cette unité électroluminescente 3 est solidarisée par collage avec une plaque de protection 7 par exemple en verre ou en matière plastique pour son encapsulation, par l'intermédiaire d'un empilement de couches minces 8, 9 et 10 successivement déposées sur l'électrode externe 6. Il convient de noter que les divers composants et couches 2 à 10 illustrés à la figure 1 ne sont nullement représentés à l'échelle de leurs épaisseurs et longueurs respectives dans le plan de coupe, pour des raisons de clarté de ce schéma.

La colle 7a utilisée est de préférence réticulable par un rayonnement UV (e.g. une colle de type acrylate ou époxy monocomposant ou bicomposants), la plaque de protection 7 étant dans ce cas choisie transparente à ce rayonnement. Cette colle est appliquée de manière connue en soi à l'état non réticulé sur la totalité de face d'assemblage 7b de la plaque 7 et/ou de l'unité électroluminescente 3 surmontée de l'empilement précité, puis la plaque 7 est appliquée par pression sur l'interface d'assemblage encollée (voir flèche A à la figure 1).

Selon l'invention, cet empilement comprend successivement ;
- une première couche intermédiaire 8 de recouvrement (« capping layer » en anglais) qui est transparente à la lumière émise par la structure 4 et qui est déposée sur l'électrode externe 6 via une méthode « douce », par exemple par évaporation sous vide, cette couche intermédiaire 8 étant à base d'un composé diélectrique par exemple de type oxyde d'étain-indium ou bien de formule SiOₓ, ZnSe, ZnO, Sb₂O₃ ;
- une sous-couche réactive métallique 9 par exemple en aluminium ou en calcium, qui est apte à réagir avec les précurseurs du dépôt par « ALD » de la couche suivante 10 avec laquelle elle est en contact pour protéger les couches sous-jacentes des effets du dépôt de cette couche ; et
- une couche externe promotrice d'adhésion 10 déposée par « ALD » et constituée d'un composé inorganique tel qu'un oxyde d'aluminium, de silicium, de zinc ou un nitrure de silicium, de telle sorte que cette couche externe 10 se conforme aux reliefs des surfaces qu'elle recouvre en étant suffisamment dense et transparente à la lumière émise.

De préférence, la couche intermédiaire 8 est constituée de SiOₓ dont l'indice varie de 2,6 à 2,4 dans le visible et qui s'évapore facilement, sans conséquence pour les couches sous-jacentes. Quant à la sous-couche réactive 9, elle peut être avantageusement constituée d'aluminium réagissant avec les précurseurs du dépôt par « ALD » de la couche 10 pour former un oxyde stable et transparent, laquelle couche 10 est alors à base de Al₂O₃ et forme une couche dense et conformante d'indice 1,6 dans le visible.

On notera que l'épaisseur des différentes couches 8 à 10 peut être modulée afin d'optimiser l'extraction lumineuse réalisée par le dispositif 1. En particulier, l'épaisseur de la sous-couche réactive métallique 9 pourra être suffisamment faible pour que la totalité de cette sous-couche 9 réagisse avec les précurseurs du dépôt «ALD », ou être plus épaisse et former alors en quelque sorte une double couche de recouvrement (« double capping layer »).

De préférence, on utilise une sous-couche réactive 9 qui réagit complètement avec ces précurseurs et, afin de limiter les pertes par transmission, une couche intermédiaire de recouvrement 8 d'épaisseur comprise entre 5 nm et 30 nm afin de limiter l'impact du dépôt « ALD » sur les couches sous jacentes.

On a fabriqué et testé des dispositifs d'affichage 1 selon un premier exemple de réalisation de l'invention, pour lesquels les principaux paramètres optiques et de colorimétrie ont été évalués en relation avec l'épaisseur variable de la couche externe 10, comme illustré aux figures 2 à 6. Dans ce premier exemple se rapportant à des diodes émettant dans le vert :
- l'électrode externe 7 est en argent et présente une épaisseur de 15 nm,
- la couche intermédiaire de recouvrement 8 est en SiOₓ et présente une épaisseur de 30 nm,
- la sous-couche réactive 9 est en aluminium et présente une épaisseur de 2 nm, et
- la couche externe 10 déposée par « ALD » est en Al₂O₃ et présente une épaisseur variable.

Il ressort des figures 2 à 6 que les maxima de radiance et de luminance se situent entre 50 nm et 60 nm d'épaisseur pour la couche externe 10. Quant à la plage d'épaisseurs de cette couche 10 pour laquelle la CIE x est la plus faible et la CIE y la plus élevée, elle est comprise entre 20 nm et 30 nm. Ainsi, selon que l'on privilégie la couleur ou bien l'efficacité lumineuse, on peut avantageusement opter pour l'une ou l'autre de ces deux plages d'épaisseurs pour déposer cette couche 10.

On a fabriqué et testé des dispositifs d'affichage 1 selon un second exemple ne faisant pas partie de la présente invention, pour lesquels les mêmes paramètres optiques et colorimétriques ont été évalués en fonction de l'épaisseur de la couche 10, comme illustré aux figures 7 à 11. Dans ce second exemple se rapportant également à des diodes émettant dans le vert :
- l'électrode externe 7 est également en argent et présente toujours une épaisseur de 15 nm,
- la couche intermédiaire de recouvrement 8 présente une épaisseur nulle (cette couche 8 étant donc absente, contrairement au premier exemple),
- la sous-couche réactive 9 est en aluminium et présente une épaisseur de 7 nm (soit 5 nm de plus que dans le premier exemple), et
- la couche externe 10 déposée par « ALD » est également en Al₂O₃ et présente une épaisseur variable.

Il ressort des figures 7 à 11 que l'optimum pour l'épaisseur de cette couche externe 10, tant en termes de luminance que de CIE, est compris entre 70 nm et 80 nm.

## Revendications

1. Dispositif électronique (1) d'affichage, d'éclairage ou de signalisation comprenant un substrat (2) revêtu sur l'une au moins de ses faces d'une unité électroluminescente (3) comportant au moins deux électrodes interne (5) et externe (6) entre lesquelles est intercalée une structure émettrice de lumière (4), au moins l'électrode externe étant transparente ou semi-transparente à la lumière émise, une plaque de protection (7) étant assemblée sur l'unité par l'intermédiaire d'une colle (7a) recouvrant une face d'assemblage (7b) de la plaque, **caractérisé en ce que** cette colle recouvre également une couche promotrice d'adhésion (10) qui surmonte l'unité en étant déposée par un dépôt de couche atomique (« ALD ») à partir de précurseurs contenant des oxydants et de l'eau et qui est à base d'au moins un composé inorganique compatible avec la colle, une sous-couche réactive métallique (9) ayant réagi avec au moins un de ces précurseurs étant intercalée sous et au contact de cette couche promotrice d'adhésion, au moins une couche intermédiaire (8) diélectrique et transparente à la lumière émise étant disposée entre l'électrode externe et ladite sous-couche réactive pour former avec ces dernières une cavité résonnante telle qu'un miroir de Bragg.

2. Dispositif (1) selon la revendication 1, **caractérisé en ce que** ladite couche intermédiaire (8) présente une épaisseur comprise entre 5 nm et 35 nm.

3. Dispositif (1) selon la revendication 1 ou 2, **caractérisé en ce que** ladite couche intermédiaire (8), déposée par une technique d'évaporation sous vide, est à base d'au moins un composé diélectrique choisi dans le groupe constitué par ceux de formule SiOₓ, ZnSe, ZnO, Sb₂O₃ et les oxydes transparents conducteurs (OTC), notamment les oxydes d'étain-indium.

4. Dispositif (1) selon la revendication 3, **caractérisé en ce que** ladite couche intermédiaire (8) est constituée d'un composé SiOₓ et présente un indice variant de 2,4 à 2,6 dans le domaine visible.

5. Dispositif (1) selon une des revendications précédentes, **caractérisé en ce que** ladite colle (7a) recouvre la totalité de ladite face d'assemblage (7b) de la plaque (7), laquelle face est sensiblement plate.

6. Dispositif (1) selon une des revendications précédentes, **caractérisé en ce que** ledit composé inorganique de ladite couche promotrice d'adhésion est choisi dans le groupe constitué par les oxydes d'aluminium, les oxydes de silicium, les oxydes de zinc et les nitrures de silicium.

7. Dispositif (1) selon une des revendications précédentes, **caractérisé en ce que** ladite sous-couche réactive (9) est constituée d'au moins un élément métallique, tel que l'aluminium ou le calcium, et présente une épaisseur inférieure ou égale à 10 nm.

8. Dispositif (1) selon une des revendications précédentes, **caractérisé en ce que** ladite couche promotrice d'adhésion (10) présente une épaisseur comprise entre 10 nm et 100 nm.

9. Dispositif (1) selon la revendication 8, **caractérisé en ce que** ladite couche promotrice d'adhésion (10) présente une épaisseur comprise entre 20 nm et 80 nm, et **en ce que** ladite sous-couche réactive (9) présente une épaisseur comprise entre 1 nm et 10 nm.

10. Dispositif (1) selon une des revendications précédentes, **caractérisé en ce que** ladite couche promotrice d'adhésion (10) est constituée d'un oxyde d'aluminium de formule Al₂O₃, et **en ce que** ladite sous-couche réactive (9) est constituée d'aluminium.

11. Dispositif (1) selon une des revendications précédentes, **caractérisé en ce que** l'électrode externe (6) est constituée d'au moins un métal (semi)transparent à la lumière émise, de préférence l'argent, l'aluminium ou le samarium.

12. Dispositif (1) selon une des revendications précédentes, **caractérisé en ce que** ladite colle (7a) est choisie réticulable (10) par un rayonnement ultraviolet, telle qu'une colle de type acrylate ou époxy, ladite plaque de protection (7) étant choisie transparente à ce rayonnement.

13. Dispositif (1) selon une des revendications précédentes, **caractérisé en ce que** ladite unité électroluminescente (3) est de type à diodes électroluminescentes organiques (« OLED »).

14. Dispositif (1) selon une des revendications précédentes, **caractérisé en ce que** ledit substrat (2) est semi-conducteur, de préférence en silicium et **en ce que** ladite plaque de protection (7) est transparente à la lumière émise par ladite unité électroluminescente (3) et est réalisée en verre ou en matière plastique.

15. Procédé de fabrication d'un dispositif (1) selon une des revendications précédentes, comprenant les étapes suivantes :
a) un dépôt sur ladite électrode externe (6), par exemple par évaporation sous vide, d'au moins une couche intermédiaire (8) qui est transparente à la lumière émise par l'unité électroluminescente (3) et qui est à base d'au moins un composé diélectrique de préférence choisi dans le groupe constitué par ceux de formule SiOₓ, ZnSe, ZnO, Sb₂O₃ et les oxydes transparents conducteurs (OTC), notamment les oxydes d'étain-indium, cette couche intermédiaire étant destinée à former une cavité résonnante telle qu'un miroir de Bragg avec cette électrode externe et la sous-couche réactive de l'étape b) et présentant de préférence une épaisseur comprise entre 5 nm et 35 nm,
b) un dépôt sur ladite couche intermédiaire d'une sous-couche réactive (9) d'au moins un métal, tel que l'aluminium ou le calcium,
c) un dépôt par « ALD » d'une couche promotrice d'adhésion (10) à base d'un composé inorganique compatible avec la colle (7a) et choisi dans le groupe constitué par les oxydes d'aluminium, les oxydes de silicium, les oxydes de zinc et les nitrures de silicium, de telle manière que la sous-couche réactive déposée à l'étape b) réagisse avec au moins un précurseur de ce dépôt contenant des oxydants et de l'eau, pour protéger les couches sous-jacentes de l'unité des effets de ce dépôt par « ALD » et pour que cette couche externe se conforme aux reliefs des surfaces qu'elle recouvre en étant stable et transparente à la lumière émise,
d) une application de la colle sur la couche promotrice d'adhésion (10) et/ou sur ladite face d'assemblage (7b) de la plaque de protection (7), pour que cette colle recouvre sensiblement la totalité de cette couche externe et de cette face d'assemblage, puis
e) un collage de la plaque sur l'unité revêtue de cette couche promotrice d'adhésion, par exemple réalisé via une réticulation de cette colle par un rayonnement ultraviolet.

## Patentansprüche

1. Elektronische Anzeige-, Beleuchtungs- oder Signalisierungsvorrichtung (1), die ein Substrat (2) umfasst, das auf mindestens einer seiner Flächen mit einer elektrolumineszenten Einheit (3) beschichtet ist, die mindestens zwei Elektroden, eine innere (5) und eine äußere, (6) umfasst, zwischen denen eine lichtemittierende Struktur (4) eingeschoben ist, wobei mindestens die äußere Elektrode gegenüber dem emittierten Licht durchlässig oder halbdurchlässig ist, wobei eine Schutzplatte (7) auf der Einheit über einen Klebstoff (7a), der eine Zusammenbaufläche (7b) der Platte abdeckt, zusammengebaut ist, **dadurch gekennzeichnet, dass** dieser Klebstoff auch eine die Haftung fördernde Schicht (10) bedeckt, die die Einheit überragt, indem sie durch Atomlagenabscheidung ("ALD") ausgehend von Vorprodukten abgeschieden wird, die Oxidationsmittel und Wasser enthalten, und die auf mindestens einer anorganischen Verbindung basiert, die mit dem Klebstoff verträglich ist, eine metallische reaktive Unterschicht (9), die mit mindestens einem dieser Vorprodukte reagiert hat, unter und in Kontakt mit dieser die Haftung fördernden Schicht eingeschoben ist, mindestens eine Zwischenschicht (8), die dielektrisch und gegenüber dem emittierten Licht durchlässig ist, zwischen der äußeren Elektrode und der reaktiven Unterschicht angeordnet ist, um mit diesen letzteren einen Hohlraumresonator, wie beispielsweise einen Bragg-Spiegel, zu bilden.

2. Vorrichtung (1) nach Anspruch 1, **dadurch gekennzeichnet, dass** die Zwischenschicht (8) eine Dicke aufweist, die zwischen 5 nm und 35 nm enthalten ist.

3. Vorrichtung (1) nach Anspruch 1 oder 2, **dadurch gekennzeichnet, dass** die Zwischenschicht (8), die durch eine Vakuumverdampfungstechnik abgeschieden wird, auf mindestens einer dielektrischen Verbindung basiert, die in der Gruppe ausgewählt ist, die aus denjenigen mit der Formel SiOₓ, ZnSe, ZnO, Sb₂O₃ und den transparenten leitfähigen Oxiden (TCO), insbesondere den Zinn-Indium-Oxiden, besteht.

4. Vorrichtung (1) nach Anspruch 3, **dadurch gekennzeichnet, dass** die Zwischenschicht (8) aus einer SiOₓ-Verbindung besteht und einen Index aufweist, der im sichtbaren Bereich von 2,4 bis 2,6 variiert.

5. Vorrichtung (1) nach einem der vorhergehenden Ansprüche, **dadurch gekennzeichnet, dass** der Klebstoff (7a) die gesamte Zusammenbaufläche (7b) der Platte (7) bedeckt, wobei die Fläche im Wesentlichen eben ist.

6. Vorrichtung (1) nach einem der vorhergehenden Ansprüche, **dadurch gekennzeichnet, dass** die anorganische Verbindung der die Haftung fördernden Schicht in der Gruppe ausgewählt wird, die aus Aluminiumoxiden, Siliziumoxiden, Zinkoxiden und Siliziumnitriden besteht.

7. Vorrichtung (1) nach einem der vorhergehenden Ansprüche, **dadurch gekennzeichnet, dass** die reaktive Unterschicht (9) aus mindestens einem metallischen Element, wie beispielsweise Aluminium oder Calcium, besteht und eine Dicke aufweist, die kleiner oder gleich 10 nm ist.

8. Vorrichtung (1) nach einem der vorhergehenden Ansprüche, **dadurch gekennzeichnet, dass** die die Haftung fördernde Schicht (10) eine Dicke aufweist, die zwischen 10 nm und 100 nm enthalten ist.

9. Vorrichtung (1) nach Anspruch 8, **dadurch gekennzeichnet, dass** die die Haftung fördernde Schicht (10) eine Dicke aufweist, die zwischen 20 nm und 80 nm enthalten ist, und dass die reaktive Unterschicht (9) eine Dicke aufweist, die zwischen 1 nm und 10 nm enthalten ist.

10. Vorrichtung (1) nach einem der vorhergehenden Ansprüche, **dadurch gekennzeichnet, dass** die die Haftung fördernde Schicht (10) aus einem Aluminiumoxid mit der Formel Al₂O₃ besteht, und dadurch, dass die reaktive Unterschicht (9) aus Aluminium besteht.

11. Vorrichtung (1) nach einem der vorhergehenden Ansprüche, **dadurch gekennzeichnet, dass** die äußere Elektrode (6) aus mindestens einem gegenüber dem emittierten Licht (halb)durchlässigen Metall, vorzugsweise Silber, Aluminium oder Samarium, besteht.

12. Vorrichtung (1) nach einem der vorhergehenden Ansprüche, **dadurch gekennzeichnet, dass** der Klebstoff (7a) durch eine ultraviolette Strahlung vernetzbar (10) ausgewählt ist, wie beispielsweise ein Klebstoff vom Typ Acrylat oder Epoxid, wobei die Schutzplatte (7) gegenüber dieser Strahlung durchlässig ausgewählt ist.

13. Vorrichtung (1) nach einem der vorhergehenden Ansprüche, **dadurch gekennzeichnet, dass** die elektrolumineszente Einheit (3) vom Typ mit organischen elektrolumineszenten Dioden ("OLED") ist.

14. Vorrichtung (1) nach einem der vorhergehenden Ansprüche, **dadurch gekennzeichnet, dass** das Substrat (2) ein Halbleiter ist, vorzugsweise aus Silizium, und dadurch, dass die Schutzplatte (7) gegenüber dem durch die elektrolumineszente Einheit (3) emittierten Licht durchlässig ist und aus Glas oder aus Kunststoff ausgeführt ist.

15. Verfahren zur Herstellung einer Vorrichtung (1) nach einem der vorhergehenden Ansprüche, das die folgenden Schritte umfasst:
a) Abscheiden, zum Beispiel durch Vakuumverdampfung, von mindestens einer Zwischenschicht (8), die gegenüber dem durch die elektrolumineszente Einheit (3) emittierten Licht durchlässig ist und die auf mindestens einer dielektrischen Verbindung basiert, die vorzugsweise in der Gruppe ausgewählt wird, die aus denjenigen mit der Formel SiOₓ, ZnSe, ZnO, Sb₂O₃ und transparenten leitfähigen Oxiden (TCO), insbesondere Zinn-Indium-Oxiden, besteht, auf der äußeren Elektrode (6), wobei diese Zwischenschicht dazu bestimmt ist, mit dieser äußeren Elektrode und der reaktiven Unterschicht von Schritt b) einen Hohlraumresonator, wie beispielsweise einen Bragg-Spiegel, zu bilden und vorzugsweise eine Dicke aufweist, die zwischen 5 nm und 35 nm enthalten ist,
b) Abscheiden einer reaktiven Unterschicht (9) aus mindestens einem Metall, wie beispielsweise Aluminium oder Calcium, auf der Zwischenschicht,
c) Abscheiden einer die Haftung fördernden Schicht (10), die auf einer anorganischen Verbindung basiert, die mit dem Klebstoff (7a) verträglich ist und in der Gruppe ausgewählt ist, die aus Aluminiumoxiden, Siliziumoxiden, Zinkoxiden und Siliziumnitriden besteht, durch "ALD", derart, dass die im Schritt b) abgeschiedene reaktive Unterschicht mit mindestens einem Vorprodukt dieser Abscheidung reagiert, das Oxidationsmittel und Wasser enthält, um die darunterliegenden Schichten der Einheit vor den Wirkungen dieser Abscheidung durch "ALD" zu schützen und damit diese äußere Schicht sich an die Reliefs der Oberflächen, die sie bedeckt, anpasst, indem sie stabil und gegenüber dem emittierten Licht durchlässig ist,
d) Aufbringen des Klebstoffs auf der die Haftung fördernden Schicht (10) und/oder auf der Zusammenbaufläche (7b) der Schutzplatte (7), damit dieser Klebstoff im Wesentlichen die gesamte äußere Schicht dieser Zusammenbaufläche bedeckt, dann
e) Kleben der Platte auf die mit dieser die Haftung fördernden Schicht beschichteten Einheit, das zum Beispiel über eine Vernetzung dieses Klebstoffs durch eine ultraviolette Strahlung ausgeführt wird.

## Claims

1. An electronic display, illumination or signage device (1) comprising a substrate (2) coated on at least one of its faces with an electroluminescent unit (3) comprising at least two electrodes, one internal electrode (5) and one external electrode (6), between which is interposed a light-emitting structure (4), at least said one external electrode being transparent or semi-transparent to the emitted light, a protective cap (7) being joined to the unit by way of an adhesive (7a) that covers an assembly face (7b) of the cap, **characterized in that** this adhesive also covers an adhesion promoting layer (10) that surmounts the unit, said layer being deposited from precursors containing oxidants and water using atomic layer deposition (ALD), and which adhesion promoting layer is based on at least one inorganic compound compatible with the adhesive, a reactive metal sublayer (9) that is able to react with at least one of these precursors being interposed beneath and in contact with this adhesion promoting layer, at least one dielectric intermediate layer (8) that is transparent to the emitted light being placed between the external electrode and said reactive sublayer so as to form, with the external electrode and said reactive sublayer, a resonant cavity such as a Bragg mirror.

2. The device (1) according to claim 1, **characterized in that** said intermediate layer (8) has a thickness of between 5 nm and 35 nm.

3. The device (1) according to claim 1 or 2, **characterized in that** said intermediate layer (8), deposited by a vacuum evaporation technique, is based on at least one dielectric compound chosen from the group consisting of compounds having the formulae SiOₓ, ZnSe, ZnO or Sb₂O₃ and transparent conductive oxides (TCOs), especially indium tin oxides.

4. The device (1) according to claim 3, **characterized in that** said intermediate layer (8) consists of a SiOₓ compound and has an index ranging from 2.4 to 2.6 in the visible domain.

5. The device (1) according to one of the preceding claims, **characterized in that** said adhesive (7a) covers all of said assembly face (7b) of the cap (7), which face is substantially flat.

6. The device (1) according to one of the preceding claims, **characterized in that** said inorganic compound of said adhesion promoting layer is chosen from the group consisting of aluminum oxides, silicon oxides, zinc oxides and silicon nitrides.

7. The device (1) according to one of the preceding claims, **characterized in that** said reactive sublayer (9) is made of at least one metallic element such as aluminum or calcium, and has a thickness of 10 nm or less.

8. The device (1) according to one of the preceding claims, **characterized in that** said adhesion promoting layer (10) has a thickness of between 10 nm and 100 nm.

9. The device (1) according to claim 8, **characterized in that** said adhesion promoting layer (10) has a thickness of between 20 nm and 80 nm, and **in that** said reactive sublayer (9) has a thickness of between 1 nm and 10 nm.

10. The device (1) according to one of the preceding claims, **characterized in that** said adhesion promoting layer (10) is made of an aluminum oxide having the formula Al₂O₃, and **in that** said reactive sublayer (9) is made of aluminum.

11. The device (1) according to one of the preceding claims, **characterized in that** the external electrode (6) is made of at least one metal that is (semi)transparent to the emitted light, preferably silver, aluminum or samarium.

12. The device (1) according to one of the preceding claims, **characterized in that** said adhesive (7a) is chosen to be curable (10) by UV radiation, such as acrylate or epoxy adhesives, said protective cap (7) being chosen to be transparent to this radiation.

13. The device (1) according to one of the preceding claims, **characterized in that** said electroluminescent unit (3) comprises organic light-emitting diodes (OLEDs).

14. The device (1) according to one of the preceding claims, **characterized in that** said substrate (2) is a semiconductor, preferably silicon, and **in that** said protective cap (7) is transparent to the light emitted by said electroluminescent unit (3) and is made of glass or plastic.

15. A process for fabricating a device (1) according to one of the preceding claims, comprising the following steps:
a) depositing on said external electrode (6), for example by vacuum evaporation, at least one intermediate layer (8) that is transparent to the light emitted by the electroluminescent unit (3) and that is based on at least one dielectric compound preferably chosen from the group consisting of compounds having the formulae SiOₓ, ZnSe, ZnO or Sb₂O₃ and transparent conductive oxides (TCOs), especially indium tin oxides, this intermediate layer being intended to form a resonant cavity such as a Bragg mirror with this external electrode and the reactive sublayer of step b) and having preferably a thickness of between 5 nm and 35 nm;
b) depositing on said intermediate layer a reactive sublayer (9) made of at least one metal such as aluminum or calcium;
c) depositing, using ALD, an adhesion promoting layer (10) based on an inorganic compound compatible with the adhesive (7a) and chosen from the group consisting of aluminum oxides, silicon oxides, zinc oxides, and silicon nitrides, such that the reactive sublayer deposited in step b) reacts with at least one precursor of this deposition so as to protect the underlying layers of the unit from being affected by this ALD deposition and so that this external layer conforms to the reliefs of the surfaces that it covers, whilst being stable and transparent to the emitted light;
d) applying the adhesive to the adhesion promoting layer (10) and/or to said assembly face (7b) of the protective cap (7), so that this adhesive covers substantially all of this external layer and of this assembly face; and then
e) bonding the cap to the unit coated with this adhesion promoting layer, for example via UV curing of this adhesive.
